# EUROPÄISCHE PATENTSCHRIFT

(11) **EP 1 233 516 B1**
(45) Veröffentlichungstag und Bekanntmachung des Hinweises auf die Patenterteilung: **24.01.2007**
(21) Anmeldenummer: 02002870.0
(22) Anmeldetag: 08.02.2002
(51) Int. Cl.: H03K 19/007

(54) **Logikschaltung, insbesondere für eisenbahntechnische Anlagen**
Logic circuit, in particular for railway systems
Circuit logique, notamment pour systèmes ferroviaires

(30) Priorität: 15.02.2001 EP 01103494
(43) Veröffentlichungstag der Anmeldung: 21.08.2002
(73) Patentinhaber: Siemens Schweiz AG, 8047 Zürich (CH)
(72) Erfinder: Ellenberger, Peter, 8003 Zürich (CH)
(74) Vertreter: Fischer, Michael

(56) Entgegenhaltungen:
- WO-A-98/38577
- DE-A- 19 805 819
- TSUDA N: "Dual and fail-safe redundancy for static mask-ROMs and PLAs" WAFER SCALE INTEGRATION, 1993. PROCEEDINGS., FIFTH ANNUAL IEEE INTERNATIONAL CONFERENCE ON SAN FRANCISCO, CA, USA 20-22 JAN. 1993, NEW YORK, NY, USA,IEEE, US, 20. Januar 1993 (1993-01-20), Seiten 57-66, XP010067727 ISBN: 0-7803-0867-0

## Beschreibung

Die vorliegende Erfindung betrifft eine Logikschaltung nach dem Oberbegriff des Patentanspruchs 1.

In den europäischen Normen EN 50126 und EN 50129 sind Sicherheitsstufen (Safety Integrity Level SIL) definiert. Für eisenbahntechnische Anlagen wie z.B. Stellwerkanlangen ist insgesamt oder für einzelne Komponenten und Schaltungen meist die höchste Stufe SIL-4 vorgeschrieben. Um solche Anforderungen zu erfüllen, werden sicherheitsrelevante Schaltungen neben anderen Massnahmen redundant, d.h. meist doppelt als 2 von 2 System ausgeführt. Eine derartige Schaltung ist z.B. aus der DE 198 05 819 A1 bekannt. Auch solche Schaltungen sind mit dem Nachteil behaftet, das ein systematischer Fehler in der Schaltungs-Architektur selbst oder auch bei einem Ausfall eines in der Schaltung befindlichen elektronischen Bauelementes ohne besondere Vorkehrungen nicht erkannt werden kann. Solche Bauelemente sind bevorzugt in der Logikfamilie FPGA (Field Programmable Gate Array) ausgeführt. Solche systematische Fehler in den genannten Bauelementen FPGA haben einen sogenannten Doppelfehler zur Folge, der einer Detektion entzogen ist: Der Vergleich von Signalen, die den beiden redundant angelegten Bauelementen oder Schaltungsteilen entstammen, offenbart diesen Fehler nicht.

Dieses Problem kann gelöst werden, indem - bei doppelter bzw. redundanter Ausführung einer Schaltung - funktionell identische Bauelemente, z.B. integrierte Schaltungen (IC integrated circuit), von verschiedenen Herstellern eingesetzt werden. Auch ist es möglich, verschiedene Typen von solchen Bauelementen einzusetzen. Eine weitere Lösung besteht darin, die gleiche zu realisierende Funktion in verschiedenen Programmierungen in ein elektronisches Bauelement einzubringen. Dabei kann das zugrundeliegende Programm verschieden erstellt und/oder die Programmierung des Bauelementes verschieden vorgenommen werden.

Diese Lösungen sind mit Nachteilen behaftet:
i) Bei der heutigen Schnelllebigkeit in der Elektronik bedeutet es einen erheblichen Verwaltungsaufwand, mehrere Typen von solchen Bauelementen zu haben, u.U. braucht es dazu mehrere Programmiersysteme.
ii) Bei Abkündigung eines Bauelementes kann unter Umständen auf einen Zweithersteller nicht mehr zurückgegriffen werden.
iii) Bei Verwendung von elektronischen Bauelemente von verschiedenen Herstellern besteht trotzdem die Gefahr, dass der im Innern befindliche Chip vom gleichen Chip-Hersteller ( Chip- oder Maskenaustausch)entstammt.
iv) Eine unterschiedliche Programmierung hat einen bedeutenden Mehraufwand zur Folge, insbesondere auch bei einem zu erbringenden Sicherheitsnachweis.

Der vorliegenden Erfindung liegt daher die Aufgabe zugrunde eine Logikschaltung anzugeben, bei der bei zwei gleichen und identisch programmierten Logikbausteinen dasselbe Programm unabhängig vom eingesetzten Logikbaustein und vom verwendeten Programmiersystem in den beiden Exemplaren abläuft, und trotzdem die Restwahrscheinlichkeit eines Doppelfehlers aufgrund eines systematischen Fehlers an einer bestimmten Stelle auf dem Chip gegen Null konvergiert.

Diese Aufgabe wird durch die im Patentanspruch 1 angegebenen Massnahmen gelöst. Vorteilhafte Ausgestaltungen der Erfindung sind in weiteren Ansprüchen angegeben.

Dadurch dass
in den je identischen Bauelementen die Daten wenigstens zweifach identisch programmiert enthalten sind und dass die identischen Bauelemente an die jeweils zugehörige Teilschaltung verschieden angeschlossen sind;
wird ein an einer Stelle des Bauelementes lokalisierter systematischer Fehler sicher erkannt.

So können sich die folgenden Vorteile zusätzlich ergeben:
i) Durch das Trennen zweier Bereiche, die identisch programmierte Daten enthalten und das Programmieren des wenigstens einen dazwischen liegenden Bereiches mit einer Füll-Logik,
   können sind die beiden Datenbereiche funktionell und elektrisch sicher getrennt (Patentanspruch 2).
ii) Dadurch, dass der nur die Füll-Logik beinhaltende Bereich nur Eingangsanschlüsse aufweist,
   können diese gemeinsam flächig auf Masse gelegt werden und reduzieren dadurch die induktive Abstrahlung und die Einkopplung (Patentanspruch 3).
iii) Dadurch, dass je identische Bauelemente mit einem weiteren, vorzugsweise als Speicher ausgebildeten Bauelement verbunden sind, das mehrere identisch programmierte Bereiche aufweist und von den identischen Bauelementen je verschieden adressierbar ist, können auch systematische Fehler in einem Speicherbauelement sicher detektiert werden (Patentanspruch 4, 7).

Die Erfindung wird nachfolgend anhand der Zeichnung beispielsweise näher erläutert. Dabei zeigen:
- Figur 1: Ausführungsform einer redundanten Logikschaltung mit zwei Bauelementen bei zweifach identischer Programmierung einschliesslich der Darstellung der Kontaktierung ;
- Figur 2a: Ausführungsform einer ersten Teilschaltung mit vier identischen Programmierungen, wobei nur eine Programmierung verwendet wird, zusammen mit den entsprechenden aktiven Anschlusszonen für das Bauelement;
- Figur 2b: Ausführungsform einer zweiten Teilschaltung mit vier identischen Programmierungen, wobei nur eine Programmierung verwendet wird, zusammen mit den entsprechenden aktiven Anschlusszonen für das Bauelement;
- Figur 2c: Prinzipdarstellung des Layouts eines Bauelementes mit einer Füll-Logik;
- Figur 3: Speicherlayout eines Speicherbauelementes mit mehreren identisch programmierten Bereichen.

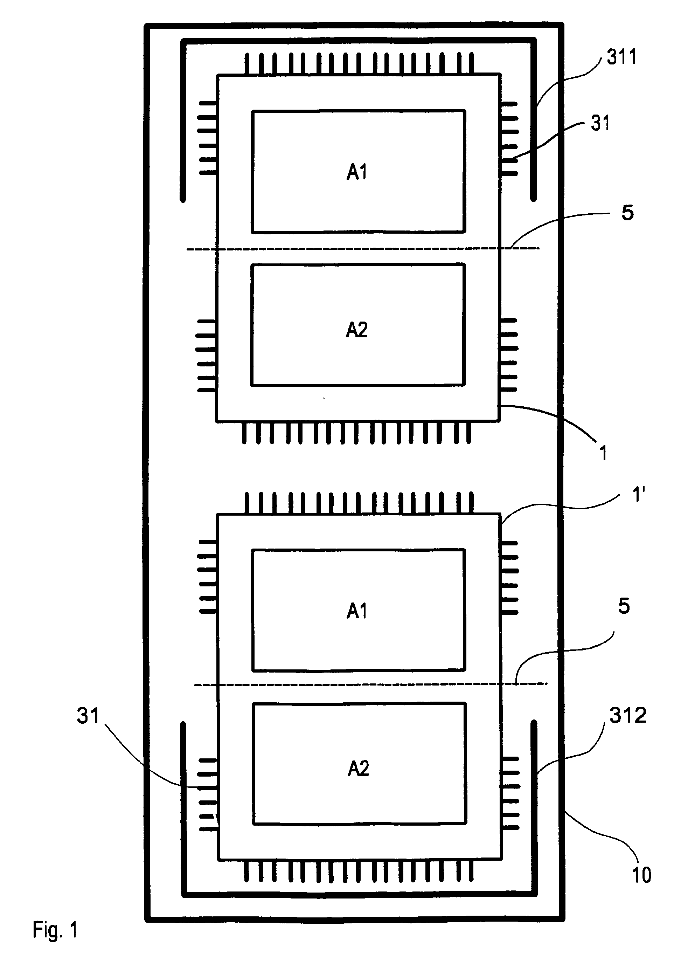

Fig. 1 zeigt eine redundante Logikschaltung 10, die in je eine Teilschaltung (als solche in Fig. 1 nicht dargestellt) mit je einem zugehörigen Bauelement 1 und 1' gegliedert ist. Die Bauelemente 1 und 1' sind vorzugsweise als FPGA-Bauelemente ausgeführt Diese Bauelemente 1, 1' sind über die Pins 31 an eine Umgebung, z.B. eine Leiterplatte, angeschlossen. Mit A1 und A2 (A area) sind abstrakte Zonen auf den beiden Bauelementen 1, 1' bezeichnet, die vorgegebene Daten und programmierte Funktionen beinhalten.

Mit einer Hochsprache, meist VHDL (Very High Speed Hardware Description Language nach IEEE 1087-1987/1993), wird die zu realisierende Logikfunktion entwickelt. Dazu stehen kombinatorische Logikbausteine, wie z.B. Gatterelemente mit den Funktionen AND, NAND, OR, Flip/Flops, Zähler, Decoder usw. zur Verfügung. Neben den vorstehend erwähnten kombinatorischen Logikbausteinen gibt es auch speichernde Logikbausteine, die in einer Anordnung beispielsweise eine Adresse, einen Maximalwert oder einen Text in ASCII (American Standard Code for Information Interchange) enthalten können. Auch diese festen Daten sind mit der Hochsprache VHDL erstellbar. Zusätzlich sind bestimmte oft wiederholt verwendbare Funktionen als Bibliothekselemente in der Sprache VHDL oder als Schaltungskombination von Logikbausteinen verfügbar. Diese Bibliothekselemente werden im Kontext VHDL auch als Subroutinen bezeichnet, diese werden dann in der Implementation in der Art von sogenannten Makros (inserts) eingefügt. Nach erfolgter Auswahl eines bestimmten FPGA - Bauelementes erfolgt eine Synthese, aus der eine sogenannte Netzliste resultiert. Mit einem Werkzeug "Place and Router" erfolgt eine örtliche Abbildung der vorgenannten Logikbausteine auf die einzelnen funktionalen Bereiche und Anschlüsse - d.h. Pins -. Zur Ausführung der vorliegenden Erfindung in wenigstens zweifach identischer funktionaler Programmierung ist darauf zu achten, dass die Lokalisation der Funktionen und der zugehörige Ein- und Ausgabepins strikt getrennt ist. Diese Trennung ist in der Fig. 1 mit einer gestrichelten Linie 5 dargestellt. Die verwendeten Anschlusszonen 311 resp. 312 führen zur entsprechenden Teilschaltung. Bei der Implementation können weitere Anforderungen, wie z.B. die Einhaltung von maximal vorgegebenen Signallaufzeiten so berücksichtigt werden, in dem diese dafür benötigten funktionalen Bereiche möglichst nahe, insbesondere an eine Ecke des Bauelementes gelegt werden. Die Qualität der angestrebten örtlichen Trennung der funktionellen Bereiche kann mit dem üblicherweise vorhandenen Layout-Editor überprüft werden.

Die Schaltung wird so aufgebaut, dass immer mindestens zwei identische Kopien der Logikschaltungen in jeden Bauelement 1 und 1' einprogrammiert werden. Bei der einen Kopie ist der Teil A1 mit der Anschlusszonen 311 verwendet, bei der andern Kopie ist der Teil A2 mit der Anschlusszone 312 verwendet. Die von den Anschlusszonen 311 und 312 ausgehenden Verbindungen der beiden Bauelemente 1, 1' dienen dem Datenaustausch und der gegenseitigen Überwachung der zwei Logikschaltungen, wobei diese Verbindungen vorzugsweise als serielle Datenkanäle ausgebildet werden, die die Informationen antivalent übertragen, so dass sie am Empfangsort sicherheitsrelevant auf Richtigkeit überprüft werden können. Diese genannten Verbindungen beziehen sich auf den Datenaustausch und die gegenseitige Überwachung der beiden Bauelemente, nicht aber auf die Datenanschlüsse nach ausserhalb

Die in Figur 1 dargestellte Ausführungsform der Erfindung wird insbesondere dann gewählt, wenn die Kapazität der verwendeten Bauelemente 1, 1' und die Anzahl der benötigten Anschlüsse knapp sind.

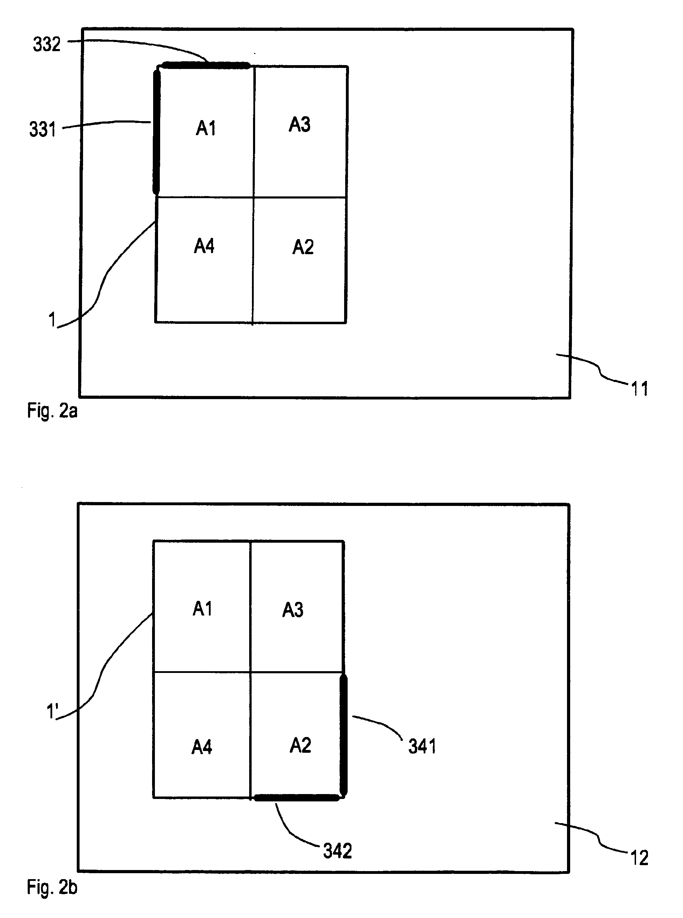

In den Figuren 2a und 2b ist eine weitere Ausführungsform der vorliegenden Erfindung dargestellt, die beim Vorhandensein von genügend Logik- und Anschlusskapazität eine noch bessere Trennung der aktiven Systeme ermöglicht. Fig. 2a zeigt eine erste Teilschaltung 11 und Fig. 2b eine zweite Teilschaltung 12. Die beiden Teilschaltungen 11 und 12 weisen je ein identisches Bauelement 1 und 1' auf und bilden die zweifach redundante Teile einer Logikschaltung. Die Einbettung der Teilschaltungen 11 und 12 in die Logikschaltung kann auf verschiedene, örtliche, mechanische und elektrische Weise erfolgen und wird in Zusammenhang mit der vorliegenden Erfindung nicht weiter ausgeführt. Die gesamte Logik in jedem Bauelement 1 und 1' ist viermal in vier identischen funktionale Bereichen - auch Kopien genannt - A1, A2, A3 und A4 einprogrammiert. In diesen beiden identischen Bauelementen 1, 1' wird für die Teilschaltung 11 die Kopie A2 mit den Anschlusszonen 331 und 332 und für die Teilschaltung 12 die Kopie A4 mit den Anschlusszonen 341 und 342 verwendet; die Anschlusszonen sind summarisch mit einer dicken Linie in den Fig. 2a und 2b dargestellt. Durch diese vorgenannte Anschaltung der Bauelemente 1 und 1' kann erreicht werden, dass sich selbst systematische Fehler, die eine ganze Zeile oder Spalte des programmierbaren Bauelementes betreffen, nicht in beiden Bauelementen 1 und 1' gleichartig auswirken können. Die Teilschaltungen 11 und 12 sind entsprechend der Belegung der Anschlusszonen 331, 332 einerseits und der Anschlusszonen 341, 342 andererseits entsprechend verschieden ausgeführt.

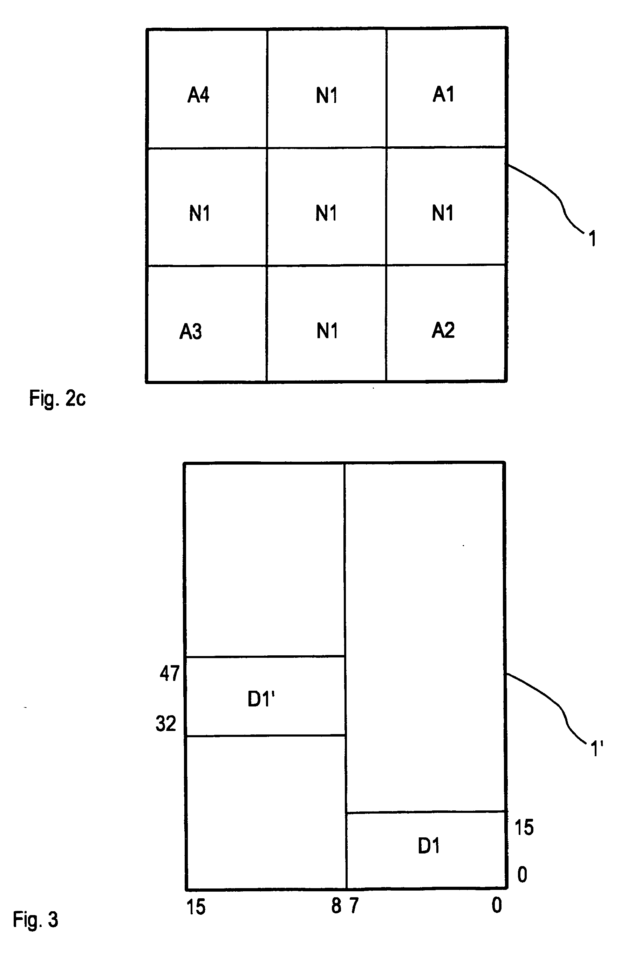

In einer weiteren Ausführungsform der vorliegenden Erfindung werden nicht benötigte Logikfunktionen, nämlich kombinatorische und speichernde mit einer hier "Füll-Logik" genannten Funktion belegt. Besonders bevorzugt ist, die beiden vorgenannten Arten von Logikbausteinen alternierend anzuordnen und jeweils nur Eingänge 31 (Eingangspin) zu spezifizieren. Die Anschlüsse auf der Leiterplattenseite zu den genannten Eingangspins sollen elektrisch auf Masse gelegt werden, um bauelement-intern wie auch auf der Seite der Leiterplatte Störeinflüsse wie Einkopplung oder Abstrahlung/ Auskopplung möglichst auszuschalten. Besonders zweckmässig ist eine flächige Ausführung der Anschlüsse zu den Eingangspins. Diese Füll-Logik wird vorzugsweise mehrfach ausgelegt, eine prinzipielle Anordnung ist der Fig. 2c zu entnehmen, die der Füll-Logik entsprechenden Bereiche sind mit dem Bezugszeichen N1 versehen.

Die vorliegende Erfindung ist nicht auf FPGA-Bauelement-Familien beschränkt. In einer weiteren Ausführungsform wird die Erfindung nachfolgend anhand eines Speicherlayoutes eines elektrisch programmierbaren Bauelementes, das vorzugsweise als Flash-EPROM ausgeführt ist, gezeigt.

In Fig. 3 ist ein wortorganisierter und byteadressierbarer Speicher 2 gezeigt. Die Organisation dieses Speichers 2 betrage n x 1 Wort, wobei ein Wort als 16 Bit definiert ist und der untere und obere Teil eines Wortes ebenfalls einzeln adressierbar sind, z.B. mit Adressleitung A0 (nicht dargestellt in Fig. 3). Die Bit-Positionen sind in der Fig. 3 von rechts nach links mit 0 .. 7 und 8 .. 15 in dezimaler Darstellung bezeichnet. Mit 0 .. 15 bzw. 32 .. 47 sind in der Fig. 3 Adressen von halben Worten bezeichnet; die angegebenen Adressen haben nur beispielhaften Charakter, insbesondere brauchen die identisch programmierten Bereiche nicht an der Bauelementadresse 0 zu beginnen. Um Doppelfehler zu vermeiden, sind bei Speicherlayout die Daten ebenfalls mehrfach vorzusehen. In Fig. 3 sind Bereiche, die identische Daten enthalten mit D1 bezeichnet. Darüber hinaus werden zur weiteren Erniedrigung einer Doppelfehlerwahrscheinlichkeit die identischen zusammenhängenden Daten an verschiedenen Adressen wenigstens einmal im tieferwertigen Byte und wenigstens einmal im höherwertigen Byte angelegt. Um auch noch Fehler auf Adress- oder Datenleitungen erkennen zu können, ist es zweckmässig, die verschiedenen Bereiche nicht exakt auf Adressen zu legen, die einer Zweierpotenz entsprechen. Darüber hinaus wäre es möglich, bestimmte Bereiche des Speichers mit einer Prüfsumme oder einem vordefinierten, unveränderlichen Speicherinhalt zusätzlich abzusichern.

In einer Anordnung mit einem FPGA-Bauelement kann vorgesehen sein, dass in der ersten Teilschaltung das FPGA-Bauelement 1 stets auf die niederwertige Hälfte des Wortspeichers 2 zugreift, während das FPGA-Bauelement in der zweiten Teilschaltung 12 stets auf die höherwertige Hälfte des Wortspeichers zugreift. Nicht dargestellt in Fig. 3 sind die FPGA-Bauelemente 1, die miteinander gekoppelt sind. Ueber eine solche Kopplung können die aus dem Speicher 2 aus verschiedenen Bereichen entstammenden und über verschiedene Leitungen zum betreffenden FPGA-Bauelement 1 übertragenen Daten auf Gleichheit, insbesondere auf Integrität geprüft werden.

Unter dem Begriff Daten werden in Zusammenhang mit der vorliegenden Erfindung auch Code für ein Prozessorsystem verstanden. Ein wesentlicher Vorteil der vorliegenden Erfindung ergibt sich dadurch, wenn der Code sogenannt positionsunabhängig ist, d.h. unabhängig von seiner Lage im Adressraum ausführbar ist.

### Liste der verwendeten Bezugszeichen

- 1, 1': Bauelement, vorzugsweise FPGA
- 2: Bauelement, vorzugsweise Flash-PROM oder EPROM
- 5: Abstrakte Trennungslinie
- 10: Logikschaltung
- 11: Erste Teilschaltung einer redundant ausgeführten Logikschaltung
- 12: Zweite Teilschaltung einer redundant ausgeführten Logikschaltung
- 31: Bauelement-Anschluss, Pin
- 311, 312: Anschlusszonen der Bauelemente 1, 1'
- 331, 332: Anschlusszonen zum funktionalen Bereich A1 auf dem Bauelement 1
- 341, 342: Anschlusszonen zum funktionalen Bereich A2 auf dem Bauelement 1'
- A1, A2, A3, A4: funktionale Bereiche auf dem Bauelement 1
- N1: Füll-Logik-Bereich auf den Bauelementen 1, 1'
- D1: Datenbereich auf den Bauelementen 1, 1'

## Patentansprüche

1. Logikschaltung, die wenigstens in zwei redundante Teilschaltungen (11, 12) gegliedert ist, die wenigstens je ein identisches und mit Daten programmierbares Bauelement (1, 1') aufweisen,
**dadurch gekennzeichnet, dass**
in den je identischen Bauelementen (1, 1') die Daten (D1) wenigstens zweifach identisch programmiert enthalten sind (A1, A2) und dass die identischen Bauelemente (1, 1') an die jeweils zugehörige Teilschaltung (11, 12) verschieden angeschlossen (311, 312; 331, 332; 341, 342) sind.

2. Logikschaltung nach Anspruch 1,
**dadurch gekennzeichnet, dass**
in den je identischen Bauelementen (1, 1') die wenigstens zweifach identisch programmierten Daten (D1) durch wenigstens einen Bereich (N1) getrennt sind, der eine Füll-Logik beinhaltet.

3. Logikschaltung nach Anspruch 2,
**dadurch gekennzeichnet, dass**
der die Füll-Logik beinhaltende Bereich (N1) nur als Eingang benutzbare Bauelementanschlüsse (31) aufweist.

4. Logikschaltung nach einem der Ansprüche 1 bis 3,
**dadurch gekennzeichnet, dass**
die je identischen Bauelemente (1, 1') mit einem weiteren mit Daten programmierbaren Bauelement (2) verbunden sind, das mehrere mit identischen Daten (D1) programmierte Bereiche aufweist und wobei von jedem identischen Bauelement (1, 1') das weitere Bauelement (2) verschieden adressierbar ist.

5. Logikschaltung, nach Anspruch 4,
**dadurch gekennzeichnet, dass**
in dem weiteren Bauelement (2) die mit identischen Daten (D1) programmierten Bereiche an Adressen liegen, die ungleich einer Zweierpotenz sind.

6. Logikschaltung nach Anspruch 5,
**dadurch gekennzeichnet, dass**
das weitere Bauelement (2) neben den mit identischen Daten (D1) programmierten Bereichen weitere Bereiche aufweist, die feste Daten oder eine Prüfsumme enthalten.

7. Logikschaltung nach einem der Ansprüche 4 bis 6,
**dadurch gekennzeichnet, dass**
die identisch programmierten Bauelemente (1, 1') gekoppelt sind und dass die aus dem weiteren Bauelement (2) entstammenden Daten über diese Kopplung auf Integrität prüfbar sind.

## Claims

1. Logic circuit, which is divided into at least two redundant sub-circuits (11, 12), which each comprise at least one identical component (1, 1') which can be programmed with data,
**characterised in that**
the data (D1) is contained in each identical component (1, 1') in an at least dual identically programmed form (A1, A2) and that the identical components (1, 1') are connected (311,312; 331,332; 341,342) to each assigned sub-circuit (11, 12) in different manners.

2. Logic circuit according to claim 1,
**characterised in that**
in each identical component (1, 1'), the at least dual identically programmed data (D1) is separated by at least one region (N1) which contains a filler logic.

3. Logic circuit according to claim 2,
**characterised in that**
the region (N1) containing the filler logic has component terminals (31) which can only be used as an input.

4. Logic circuit according to one of claims 1 to 3,
**characterised in that**
each identical component (1, 1') is connected to a further component (2) which can be programmed with data, said component (2) comprising a number of regions programmed with identical data (D1) and with the further component (2) being able to be addressed in a different manner by each identical component (1, 1').

5. Logic circuit according to claim 4,
**characterised in that**
in the further component (2), the regions programmed with identical data (D1) lie at addresses which are unequal to the power of two.

6. Logic circuit according to claim 5,
**characterised in that**
in addition to the regions programmed with identical data (D1), the further component (2) comprises further regions which contain fixed data or a checksum.

7. Logic circuit according to one of claims 4 to 6,
**characterised in that**
the identically programmed components (1, 1') are coupled and that the data emanating from the further component (2) can be checked for integrity by way of this coupling.

## Revendications

1. Circuit logique qui se subdivise en au moins deux sous circuits (11, 12) redondants qui ont respectivement un composant (1, 1') identique et pouvant être programmé par des données,
**caractérisé en ce que**
les données (D1) sont dans chaque composant (1, 1') identiques contenues de manière programmée identiquement au moins deux fois (A1, A2) et **en ce que** les composants (1, 1') identiques sont raccordés (311, 312, 331, 332, 341, 342) différemment aux sous circuits (11, 12) associés respectifs.

2. Circuit logique suivant la revendication 1,
**caractérisé en ce que**
dans chaque composant (1, 1') identique, les données (D1) programmées de manière identique au moins deux fois sont séparés par au moins une partie (N1) qui comprend une logique de remplissage.

3. Circuit logique suivant la revendication 2,
**caractérisé en ce que**
la partie (N1) contenant la logique de remplissage a des bornes (31) de composant ne pouvant être utilisés que comme entrée.

4. Circuit logique suivant l'une des revendications 1 à 3,
**caractérisé en ce que** les composants (1, 1') identiques sont reliés respectivement à un autre composant (2) programmable par des données et ayant plusieurs parties programmées par des données (D1) identiques et dans lequel l'autre composant (2) peut être adressé différemment par chaque composant (1, 1') identique.

5. Circuit logique suivant la revendication 4,
**caractérisé en ce que** dans l'autre composant (2) les parties programmées par des données (D1) identiques se trouvent à des adresses qui diffèrent d'une puissance de deux.

6. Circuit logique suivant la revendication 5,
**caractérisé en ce que** l'autre composant (2) a, outre les parties programmées par des données (D1) identiques, d'autres parties qui contiennent des données fixes ou une somme de contrôle.

7. Circuit logique suivant l'une des revendications 4 à 6,
**caractérisé en ce que** les composants (1, 1') programmés de façon identique sont couplés et **en ce que** l'intégrité des données provenant de l'autre composant (2) peut être contrôlée par ce couplage.
